Europäisches Patentamt

(19) European Patent Office

Office européen des brevets

(11) Publication number : **0 440 799 B1**

# EUROPEAN PATENT SPECIFICATION

(12)

(45) Date of publication of patent specification :
11.10.95 Bulletin 95/41

(51) Int. Cl.⁶ : **H01B 12/10, H01B 13/00**

(21) Application number : **90907477.5**

(22) Date of filing : **28.05.90**

(86) International application number :
**PCT/JP90/00680**

(87) International publication number :
**WO 91/03060 07.03.91 Gazette 91/06**

(54) SUPERCONDUCTIVE WIRE MATERIAL AND METHOD OF PRODUCING THE SAME.

(30) Priority : 25.08.89 JP 219385/89
08.01.90 JP 1400/90
23.01.90 JP 12886/90
12.03.90 JP 60757/90

(43) Date of publication of application :
14.08.91 Bulletin 91/33

(45) Publication of the grant of the patent :
11.10.95 Bulletin 95/41

(84) Designated Contracting States :
CH DE FR GB IT LI

(56) References cited :
GB-A- 2 038 532
JP-A- 2 148 517
JP-A-61 174 365
JP-A-61 174 366
JP-A-61 232 510
JP-A-62 110 207
JP-A-62 110 208
JP-A-62 211 358
JP-A-62 283 505
JP-B- 0 525 239
JP-B- 5 539 845
US-A- 3 465 430
US-A- 4 078 299
US-A- 4 414 428
US-A- 4 803 310

(73) Proprietor : THE FURUKAWA ELECTRIC CO.,
LTD.
6-1, Marunouchi 2-chome
Chiyoda-ku
Tokyo 100 (JP)

(72) Inventor : MIURA, Ohsuke
Kanagawa-ryo
211, Oguchinakacho
Kanagawa-ku Yokohama-shi Kanagawa (JP)
Inventor : MATSUMOTO, Kaname
Furukawadenko-shataku
34-5, Miyagaya
Nishi-ku Yokohama-shi Kanagawa (JP)
Inventor : TANAKA, Yasuzo
8-6, Takinoue
Naka-ku
Yokohama-shi Kanagawa (JP)
Inventor : SHIGA, Shoji
771-2, Shukugocho
Utsunomiya-shi
Tochigi (JP)

(74) Representative : Matthews, Derek Peter et al
Frank B. Dehn & Co.
Imperial House
15-19 Kingsway
London WC2B 6UZ (GB)

## Description

## TECHNICAL FIELD

The present invention relates to a superconducting wire used for a superconducting electromagnet and methods of manufacturing a superconducting wire structure.

## BACKGROUND ART

In recent years, superconducting wires made of various materials have remarkably been put to practical use. To advance the practical use of such wires, it is important to increase the amount of electric current, which can flow through the wires, that is, to increase the critical current density (Jc).

One method of increasing Jc is increasing the pinning force for capturing magnetic flux in a superconducting wire within a magnetic field produced by a coil of the superconducting wire, which magnetic flux enters the superconducting wire. This method is called "pin stop", and a portion having the pin stop effect is termed "pinning center."

In the prior art, an alloy superconducting wire is subjected to heat treatment at the time of final wire drawing, and a normal conducting deposited portion or strained portion, produced through the heat treatment, is employed as a pinning center.

It is known that a pinning center in a compound superconducting wire is normally present at a grain boundary. The pinning center in the compound superconducting wire may be explained, for example, with reference to a manufacturing method illustrated in Figs. 5A to 5E. An Nb or Nb alloy ingot 41, as shown in Fig. 5A, is buried in a bronze (containing Sn) pipe 42, as shown in Fig. 5B. The resultant structure is processed into a hexagonal wire element 43 (see Fig. 5C). Subsequently, as is shown in Fig. 5D, a plurality of wire elements 43 are gathered and buried in a bronze (containing Sn) pipe 44. After the resultant structure is subjected to wire drawing, as illustrated in Fig. 5E, it is thermally treated to produce an intermetallic compound layer ($Nb_3Sn$ layer), thus obtaining a superconducting wire. The intermetallic compound of the superconducting wire is a polycrystal. A cross-sectional structure of the polycrystal is shown, for example, in Fig. 5F. That is, there are crystal grains 45 of $Nb_3Sn$ and grain boundaries 46.

In order to enhance the Jc of the above compound superconducting wire, it is generally practiced to control parameters such as the size, density and contamination of the grain boundaries, thereby introducing strong pinning centers. Conventionally, these parameters are controlled by varying the temperature and time for heat treatment or adding a third substance, such as Ta, Ti, Hf or Ga in a Nb core or a matrix to make the grain boundaries dirty.

Regarding an alloy superconducting wire, in order to make pinning centers function effectively to enhance the pin stop effect, it is important to appropriately determine the size and arrangement of the pinning centers. Where the pinning centers are introduced by heat treatment or by utilizing process strain, it is very difficult to suitably control the sizes of normal conducting deposited portions and strained portions and the distance therebetween. Further, when the wire is finally processed, heat treatment must be repeated several times. Consequently, manufacturing time increases and also the number of manufacturing steps increases.

Where grain boundaries are employed as pinning centers in the compound superconducting wire, a pinning force Fp and an applied magnetic field B have the relationship:

$$Fp \propto (1 - B/Bc)^2$$

where Bc: critical magnetic field.

As the intensity of the applied magnetic field approaches that of the critical magnetic field, the pinning force decreases suddenly and Jc decreases at high magnetic field, which is disadvantageous. GB-A-2038532 discloses a superconducting wire containing pinning centres of diameter 50 Angstroms or less.

The present invention has been made in consideration of the above circumstances and its object is to provide a superconducting wire made of various superconducting substances and having enhanced pin stop effect and Jc.

## DISCLOSURE OF THE INVENTION

The present invention provides a superconducting wire having an elongated filament comprising a plurality of elongated superconducting wire elements (3), said superconducting wire elements each being made of an alloy-based superconducting substance (8) and said superconducting wire elements each including a pinning center made of at least one wire of a non-superconducting substance (9) buried in said alloy-based superconducting substance and extending in the longitudinal direction of said filament,

characterised in that

said at least one wire of non-superconducting substance has a diameter greater than or equal to 7 nm and less than 500 nm.

It is necessary that the diameter of the wire of non-superconducting substance be greater than or equal to 7 nm and less than 500 nm. In addition, it is desirable that the ratio of the non-superconducting substance in the filament be 40% or less. When the diameter of the wire of non-superconducting substance is less than 7 nm, this diameter is too small as a pinning center, and the pin stop effect lowers. Thus, the enhancement of Jc cannot be expected. On the other hand, when the diameter of the wire exceeds 500 nm, the matching with the lattice of magnetic flux is not good. When the ratio of the non-superconducting substance in the filament exceeds 40%, the superconducting electron density in the filament decreases, and the enhancement of Jc cannot be expected.

A superconducting wire structure can be manufactured using a superconducting wire of the invention by a method comprising the steps of:

burying said at least one wire of a non-superconducting substance in the longitudinal direction of each of said superconducting wire elements;

gathering a plurality of said superconducting wire elements;

drawing the gathered superconducting wire elements into a filament; and

gathering a plurality of said filaments and reducing the diameter of the resultant structure to obtain the superconducting wire structure.

Also, a superconducting wire structure can be manufactured using a superconducting wire of the invention by a method comprising the steps of:

burying a plurality of said wires of a non-superconducting substance in the longitudinal direction of said superconducting wire elements;

reducing the diameter of the resultant structure to obtain a filament; and

gathering a plurality of said filaments and reducing the diameter of the resultant body to obtain the superconducting wire structure.

In these manufacturing methods, it is desirable that the diameter of the wire of non-superconducting substance be 7 to 500 nm. When the diameter of the wire of non-superconducting substance is less than 7 nm, this diameter is too small as a pinning center, and it is difficult to pin-stop the lattice of magnetic flux. Thus, the enhancement of Jc cannot be expected. When the diameter of the wire exceeds 500 nm, the matching with the lattice of magnetic flux deteriorates and the enhancement of Jc cannot be expected.

According to this method, it is possible to freely control, at the design stage, the size, type, distance and position of the pinning center of non-superconducting substance introduced into the filament, in accordance with the use of the wire, e.g. the intensity of magnetic field. Thus, the matching with the lattice of magnetic flux can be enhanced and the elemental pinning force can be effectively exhibited and increased, whereby Jc can be greatly improved. Besides, since no heat treatment is performed, the manufacturing time and cost can be reduced.

In the above alloy-based superconducting wire, it is desirable that the alloy which forms the alloy-based superconducting wire element be a known superconducting substance, e.g. NbTi alloy.

It is desirable that the non-superconducting substance for forming the pinning center be Cu or a Cu alloy; Cu or a Cu alloy coated with Nb or Ta; Cu or a Cu alloy mixed with 0.5 to 5% by weight of magnetic substance; Cu or a Cu alloy coated with Nb or Ta and mixed with 0.1 to 5% by weight of magnetic substance; Ag or Au or an alloy of Ag or Au; or Ag or Au or an alloy of Ag or Au, mixed with 0.5 to 5% by weight of magnetic substance.

## BRIEF DESCRIPTION OF THE DRAWINGS

Figs. 1A to 1D illustrate a method of manufacturing a superconducting wire according to Example 1.
Figs. 5A to 5F illustrate a conventional method of manufacturing a compound superconducting wire.

## BEST MODES OF THE INVENTION

### Example

The outer periphery of a Cu rod having a diameter of 3 mm was coated with a Nb sheet. The Cu rod was inserted into a through hole formed in a central part of a NbTi alloy wire having a diameter of 35 mm. A plurality of NbTi alloy wires were inserted into a Cu billet having a diameter of 453 mm. Thereafter, the Cu billet was hot-excluded at 700 °C and drawn (the billet was removed during drawing), thus obtaining a superconducting wire element 1 of NbTi alloy having a hexagonal final cross section and a distance of 1.83 mm between parallel sides. In this case, the Cu rod serves as a pinning center, as will be described below.

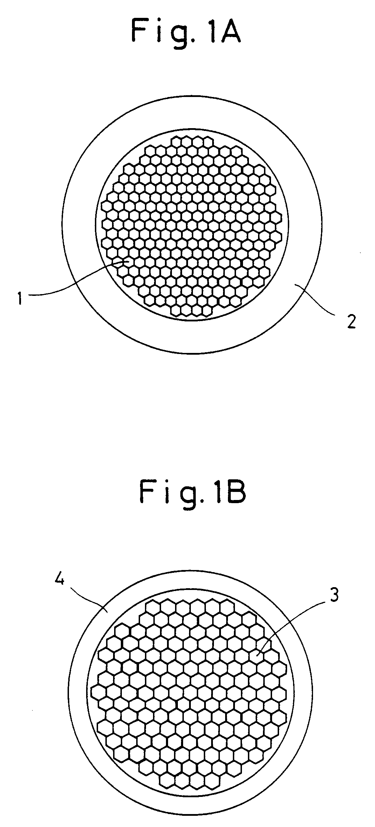

As is shown in Fig. 1A, 253 superconducting wire elements 1 were gathered and inserted into a Cu-10% Ni alloy billet 2 having its outer peripheral surface coated with Nb and having a diameter of 453 mm. The resultant body was hot-extruded at 700 °C and the diameter thereof was reduced, thus obtaining a secondary wire element (filament) 3 having a hexagonal final cross section and a distance of 3.15 mm between parallel sides (see Fig. 1B). The secondary wire element 3 is a composite of a number of superconducting wire elements 1.

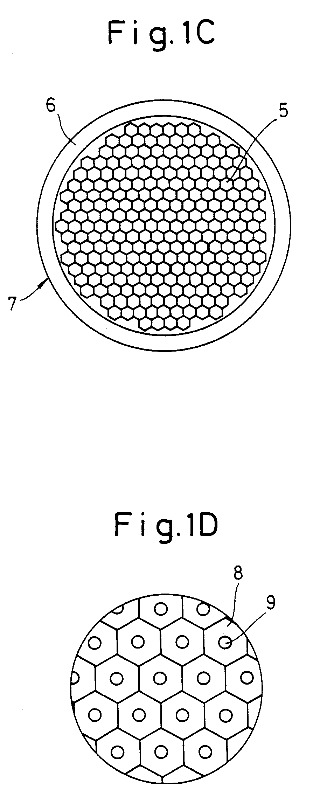

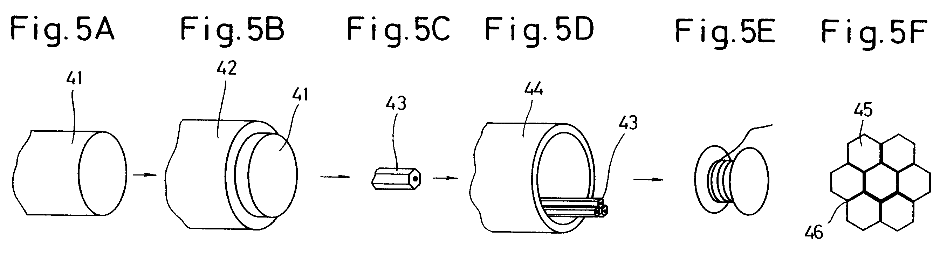

Then, as is shown in Fig. 1B, 151 filaments 3 were gathered and inserted into a Cu billet 4 having a diameter of 453 mm. The resultant body was hot-extruded at 600 °C and the diameter thereof was reduced, thus obtaining a tertiary wire element 5 having a hexagonal final cross section and a distance of 2.6 mm between parallel sides (see Fig. 1C). The tertiary wire element 5 is a composite of a number of secondary wire elements 3.

The 241 tertiary wire elements 5 were gathered and buried in a CU billet 6 having a diameter of 453 mm, as shown in Fig. 1C. The resultant structure was hot-extruded at 600 °C and the diameter thereof was reduced, thus obtaining a superconducting wire 7 having a diameter of 10 mm or less. If the cross section of each superconducting wire element 1 constituting the superconducting wire 7, it is found that a Cu pinning center 9 coated with a Nb sheet is present at the center of a hexagonal NbTi alloy 8 (see Fig. 1D).

For example, when the superconducting wire 7 had the diameter of 0.2 mm, the diameter of the filament 3 was 0.507 μm, the diameter of the pinning center 9 was 3.7 nm, and the distance between adjacent pinning centers 9 was 30 nm.

Current densities were measured with respect to the above-stated superconducting wire having Cu pinning centers, a superconducting wire manufactured in like manner with pinning centers of Ag-30 wt% Pd alloy, and a superconducting wire of a NbTi alloy in which pinning centers were introduced by a conventional heat treatment method. The results are shown in Table 1.

EP 0 440 799 B1

Table 1

| Superconduct-ing Wires | No. | Type of Pins | Heat Treatment | Diameter of Filament ($\mu$ m) | Pin Size (n m) | Pin Density (%) | J C (A/cm$^2$) at 1 T | J C (A/cm$^2$) at 5 T |
|---|---|---|---|---|---|---|---|---|
| | 1 | C u | No | 0.1 | 0.1 | 1 | $3.4 \times 10^5$ | $1.9 \times 10^5$ |
| | 2 | C u | No | 0.5 | 5 | 10 | $7.2 \times 10^5$ | $3.1 \times 10^5$ |
| Wire of this invention | 3 | C u | No | 1 | 10 | 15 | $9.6 \times 10^5$ | $4.7 \times 10^5$ |
| | 4 | C u | No | 10 | 1000 | 50 | $3.1 \times 10^5$ | $2.1 \times 10^5$ |
| | 5 | C u | No | 100 | 10000 | 50 | $2.1 \times 10^5$ | $1.1 \times 10^5$ |
| | 6 | Ag-30wt%Pd | No | 0.1 | 0.1 | 1 | $3.7 \times 10^5$ | $2.0 \times 10^5$ |
| Wire of this invention | 7 | Ag-30wt%Pd | No | 0.5 | 7 | 12 | $9.1 \times 10^5$ | $4.3 \times 10^5$ |
| Wire of this invention | 8 | Ag-30wt%Pd | No | 1 | 10 | 15 | $9.8 \times 10^5$ | $5.0 \times 10^5$ |
| | 9 | Ag-30wt%Pd | No | 10 | 1000 | 50 | $3.2 \times 10^5$ | $2.3 \times 10^5$ |
| | 10 | Ag-30wt%Pd | No | 100 | 10000 | 50 | $2.2 \times 10^5$ | $1.3 \times 10^5$ |
| Conventional Wire | 11 | $\alpha$ - T i | Yes | 1 | Not Measured | Not Measured | $6.5 \times 10^5$ | $2.2 \times 10^5$ |
| Conventional Wire | 12 | —————— | No | 1 | —————— | —————— | $4.1 \times 10^4$ | $2.5 \times 10^4$ |

Note: The pin density indicates the percentage (%) of pins in the filament.

As is seen from Table 1, any of the superconducting wires according to the present Example has a Jc remarkably higher than that of conventional superconducting wire No. 12. The wires Nos. 2, 3, 7 and 8 have higher Jc than conventional wire No. 11. These results seem to have stemmed from the improved matching between the magnetic lattice and the size, position, etc. of the pinning center and also the enhanced pin stop effect.

## Claims

1. A superconducting wire having an elongated filament comprising a plurality of elongated superconducting wire elements (3), said superconducting wire elements each being made of an alloy-based superconducting substance (8) and said superconducting wire elements each including a pinning center made of at least one wire of a non-superconducting substance (9) buried in said alloy-based superconducting substance and extending in the longitudinal direction of said filament,
    characterised in that
    said at least one wire of non-superconducting substance has a diameter greater than or equal to 7 nm and less than 500 nm.

2. A method of manufacturing a superconducting wire structure using the superconducting wire according to claim 1, said method comprising the steps of:
    burying said at least one wire of a non-superconducting substance in the longitudinal direction of each of said superconducting wire elements;
    gathering a plurality of said superconducting wire elements;
    drawing the gathered superconducting wire elements into a filament; and
    gathering a plurality of said filaments and reducing the diameter of the resultant structure to obtain the superconducting wire structure.

3. A method of manufacturing a superconducting wire structure using the superconducting wire according to claim 1, said method comprising the steps of:
    burying a plurality of said wires of a non-superconducting substance in the longitudinal direction of said superconducting wire elements;
    reducing the diameter of the resultant structure to obtain a filament; and
    gathering a plurality of said filaments and reducing the diameter of the resultant body to obtain the superconducting wire structure.

4. The superconducting wire according to claim 1, wherein said non-superconducting substance is Cu or a Cu alloy.

5. The superconducting wire according to claim 4, wherein 0.1 to 5% by weight of magnetic substance is added to the non-superconducting substance.

6. The superconducting wire according to claim 4, wherein said non-superconducting substance is coated with Nb or Ta.

7. The superconducting wire according to claim 6, wherein 0.1 to 5% by weight of magnetic substance is added to the non-superconducting substance.

8. The superconducting wire according to claim 1, wherein said non-superconducting substance is Ag or Au or an alloy of Ag or Au.

9. The superconducting wire according to claim 8, wherein 0.1 to 5% by weight of magnetic substance is added to the non-superconducting substance.

## Patentansprüche

1. Supraleitender Draht mit einem langgestreckten Filament mit einer Mehrzahl von langgestreckten supraleitenden Drahtelementen (3), wobei die supraleitenden Drahtelemente jeweils aus einer supraleitenden Substanz (8) auf Basis einer Legierung gefertigt sind und die supraleitenden Drahtelemente jeweils ein Pinning-Zentrum aufweisen, das aus mindestens einem Draht aus einer nichtsupraleitenden Substanz (9) gefertigt ist, der in der supraleitenden Substanz auf Basis einer Legierung eingebettet ist und sich in Längsrichtung des Filaments erstreckt,

dadurch gekennzeichnet,

daß der mindestens eine Draht aus einer nicht-supraleitenden Substanz einen Durchmesser aufweist, der größer als oder gleich 7 nm und kleiner als 500 nm ist.

2. Verfahren zum Herstellen einer supraleitenden Drahtstruktur unter Verwendung des supraleitenden Drahtes gemäß Anspruch 1, wobei das Verfahren die folgenden Schritte aufweist:

Einbetten des mindestens einen Drahtes aus einer nichtsupraleitenden Substanz in Längsrichtung jedes der supraleitenden Drahtelemente;

Ansammeln einer Mehrzahl der supraleitenden Drahtele-mente;

Zusammenfassen der angesammelten supraleitenden Drahtelemente in ein Filament; und

Ansammeln einer Mehrzahl der Filamente und Reduzieren des Durchmessers der resultierenden Struktur, um die supraleitende Drahtstruktur zu erhalten.

3. Verfahren zum Herstellen einer supraleitenden Drahtstruktur unter Verwendung des supraleitenden Drahtes gemäß Anspruch 1, wobei das Verfahren die folgenden Schritte aufweist:

Einbetten einer Mehrzahl der Drähte einer nicht-supraleitenden Substanz in Längsrichtung der supraleitenden Drahtelemente;

Reduzieren des Durchmessers der resultierenden Struktur, um ein Filament zu erhalten; und

Ansammeln einer Mehrzahl der Filamente und Reduzieren des Durchmessers des resultierenden Körpers, um die supraleitende Drahtstruktur zu erhalten.

4. Supraleitender Draht nach Anspruch 1, wobei die nichtsupraleitende Substanz Cu oder eine Cu-Legierung ist.

5. Supraleitender Draht nach Anspruch 4, wobei 0,1 bis 5 Gewichtsprozent einer magnetischen Substanz zu der nicht-supraleitenden Substanz hinzugefügt ist.

6. Supraleitender Draht nach Anspruch 4, wobei die nichtsupraleitende Substanz mit Nb oder Ta beschichtet ist.

7. Supraleitender Draht nach Anspruch 6, wobei 0,1 bis 5 Gewichtsprozent einer magnetischen Substanz zu der nicht-supraleitenden Substanz hinzugefügt ist.

8. Supraleitender Draht nach Anspruch 1, wobei die nichtsupraleitende Substanz Ag oder Au oder eine Legierung von Ag oder Au ist.

9. Supraleitender Draht nach Anspruch 8, wobei 0,1 bis 5 Gewichtsprozent einer magnetischen Substanz zu der nicht-supraleitenden Substanz hinzugefügt ist.

**Revendications**

1. Fil supraconducteur ayant un filament allongé comprenant plusieurs éléments de fil supraconducteur allongés (3), lesdits éléments de fil supraconducteur étant constitués chacun d'une substance supraconductrice à base d'alliage (8) et lesdits éléments de fil supraconducteur comprenant chacun un centre de pincement constitué d'au moins un fil de substance non supraconductrice (9) incorporé à ladite substance supraconductrice à base d'alliage et s'étendant dans la direction longitudinale dudit filament,

caractérisé en ce que

au moins l'un des fils de substance non supraconductrice a un diamètre supérieur ou égal à 7 nm et inférieur à 500 nm.

2. Procédé de fabrication d'une structure à fil supraconducteur utilisant le fil supraconducteur selon la revendication 1, ledit procédé comprenant les opérations suivantes :

incorporer au moins un fil de substance non supraconductrice dans la direction longitudinale de chacun desdits éléments de fil supraconducteur;

rassembler plusieurs éléments de fil supraconducteur;

étirer les éléments de fil supraconducteur rassemblés pour former un filament; et

rassembler plusieurs desdits filaments et diminuer le diamètre de la structure obtenue pour obtenir la structure de fil supraconducteur.

3. Procédé de fabrication d'une structure à fil supraconducteur utilisant le fil supraconducteur selon la revendication 1, ledit procédé comprenant les opérations suivantes :

incorporer plusieurs desdits fils d'une substance non supraconductrice dans la direction longitudinale desdits éléments de fil supraconducteur;

diminuer le diamètre de la structure obtenue pour obtenir un filament; et

rassembler plusieurs desdits filaments et diminuer le diamètre de l'ensemble obtenu afin d'obtenir la structure de fil supraconducteur.

4. Fil supraconducteur selon la revendication 1, dans lequel ladite substance non supraconductrice est du Cu ou un alliage de Cu.

5. Fil supraconducteur selon la revendication 4, dans lequel on ajoute de 0,1 à 5% en poids de substance magnétique à la substance non supraconductrice.

6. Fil supraconducteur selon la revendication 4, dans lequel ladite substance non supraconductrice est revêtue de Nb ou de Ta.

7. Fil supraconducteur selon la revendication 6, dans lequel on ajoute de 0,1 à 5% en poids de substance magnétique à la substance non supraconductrice.

8. Fil supraconducteur selon la revendication 1, dans lequel ladite substance non supraconductrice est Ag ou Au ou un alliage de Ag ou Au.

9. Fil supraconducteur selon la revendication 8, dans lequel on ajoute de 0,1 à 5% en poids de substance magnétique à la substance non supraconductrice.

# Fig. 1A

# Fig. 1B

# Fig.1C

# Fig.1D

Fig.5A  Fig.5B  Fig.5C  Fig.5D  Fig.5E  Fig.5F